# DEMANDE DE BREVET EUROPEEN

(11) **EP 2 105 959 A2**
(43) Date de publication de la demande: **30.09.2009**
(21) Numéro de dépôt: 09155772.8
(22) Date de dépôt: 20.03.2009
(51) Int. Cl.: H01L 21/768

(54) **Procédé de formation de niveaux d'interconnexion d'un circuit intégré**

(30) Priorité: 28.03.2008 FR 0852035
(71) Demandeur: STMicroelectronics (Crolles 2) SAS, 38920 Crolles (FR)
(72) Inventeur: Vannier, Patrick, 38420, LE VERSOUD (FR)
(74) Mandataire: de Beaumont, Michel

(57) **Abrégé**

L'invention concerne un procédé de formation de niveaux d'interconnexion d'un circuit intégré comprenant les étapes suivantes :
(a) former un niveau d'interconnexion (Ni, Nᵢ₊₁....) comprenant des pistes conductrices (40, 64, 74) et des vias (65, 76), séparés par un matériau diélectrique poreux (42, 50, 78) ;
(b) former, sur le niveau d'interconnexion, une couche (46, 70, 80) en un matériau isolant non poreux, ladite couche comprenant des ouvertures (48, 72, 82) au-dessus de portions de matériau diélectrique poreux (42, 50, 78) ;
(c) répéter les étapes (a) et (b) pour obtenir le nombre adéquat de niveaux d'interconnexion ; et
(d) réaliser un recuit de la structure.

## Description

### Domaine de l'invention

La présente invention concerne un circuit intégré et, plus particulièrement, un procédé de fabrication de niveaux d'interconnexion d'un circuit intégré.

### Exposé de l'art antérieur

Les circuits intégrés sont composés d'un grand nombre de composants électroniques qui sont formés dans et sur une plaquette semiconductrice. Pour relier convenablement ces composants, plusieurs niveaux d'interconnexion forment la partie supérieure des circuits intégrés. Chaque niveau d'interconnexion comprend des pistes conductrices. Des vias sont formés pour relier des pistes conductrices de différents niveaux d'interconnexion.

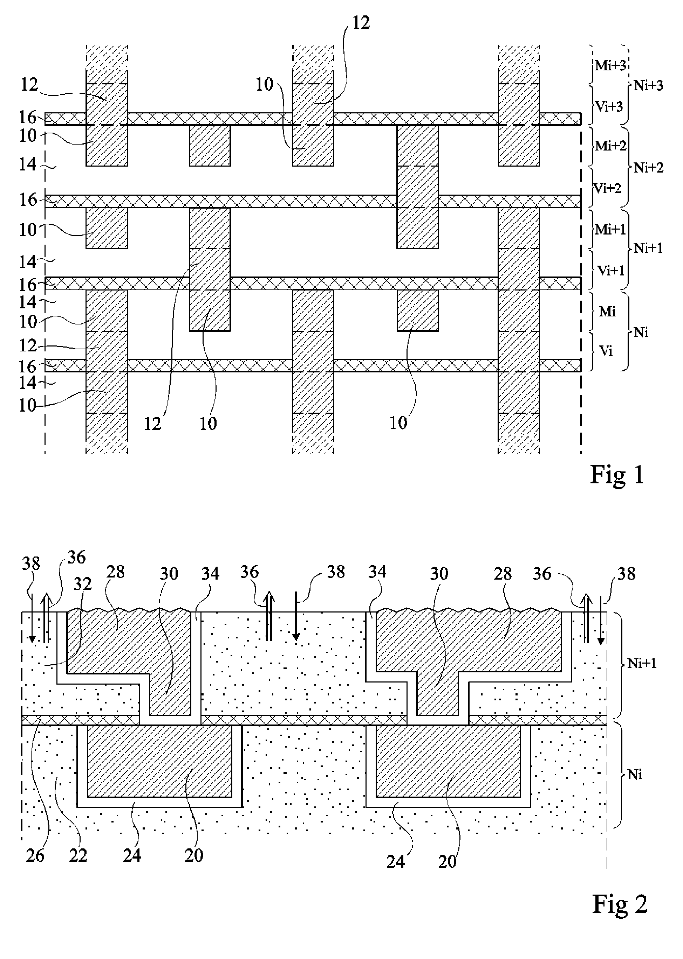

La figure 1 est une vue en coupe d'un exemple d'empilement de plusieurs niveaux d'interconnexion (Nᵢ, Nᵢ₊₁, Nᵢ₊₂...) d'un circuit intégré, le niveau N₁ étant le niveau d'interconnexion le plus proche des composants électroniques.

Chaque niveau d'interconnexion Ni comprend une partie Mi dans laquelle sont formées des pistes conductrices 10, située au-dessus d'une partie Vi dans laquelle sont formés des vias 12 de contact entre pistes de niveaux d'interconnexion adjacents (couramment, les vias du niveau N₁ sont de nature distincte des vias des autres niveaux). Dans cette figure, la coupe est faite de telle sorte que les pistes sont coupées dans le sens de leur largeur, ce qui fait que les pistes conductrices 10 apparaissent de même section que les vias 12. Les vias 12 permettent de relier convenablement deux pistes conductrices 10 situées dans deux niveaux d'interconnexion voisins. A titre d'exemple, les pistes conductrices 10 et les vias 12 peuvent être en cuivre. Un matériau diélectrique 14 sépare les pistes conductrices 10 les unes des autres et les vias 12 les uns des autres.

De nos jours, les composants électroniques formés dans des circuits intégrés fonctionnent à des fréquences de plus en plus élevées. L'augmentation de la fréquence implique l'augmentation des valeurs des capacités parasites qui se créent entre les différentes portions conductrices. De plus, la miniaturisation continue des composants électroniques implique la diminution de la taille des pistes conductrices ainsi que la diminution des distances entre pistes et entre vias, ce qui augmente également les valeurs des capacités parasites. Les capacités parasites peuvent fortement perturber le fonctionnement d'un circuit. On cherche donc à diminuer au maximum ces capacités parasites et, pour cela, on utilise, entre les différentes portions conductrices, des matériaux diélectriques poreux ayant des permittivités relatives très faibles (matériaux dits "low-k"), typiquement inférieures à 3.

Cependant, la porosité du matériau diélectrique 14 pose divers problèmes. Notamment, le cuivre des pistes conductrices 10 diffuse plus facilement dans des matériaux diélectriques poreux que dans des matériaux diélectriques non poreux. Pour limiter cette diffusion, il est particulièrement utile de former, entre deux niveaux d'interconnexion voisins, une couche 16 qui, de façon classique, stoppe la diffusion du matériau conducteur d'un niveau d'interconnexion vers le matériau diélectrique du niveau d'interconnexion supérieur et qui constitue une couche d'arrêt de gravure. Les vias 12 traversent la couche 16. A titre d'exemple, la couche 16 peut être en nitrure de carbone et de silicium (SiCN). On a également proposé de former une couche barrière (non représentée) autour des pistes conductrices et des vias, cette couche étant en un matériau conducteur propre à éviter la diffusion du matériau conducteur présent dans un niveau d'interconnexion vers le matériau diélectrique poreux du même niveau d'interconnexion. Cette couche barrière est, par exemple, composée de tantale et de nitrure de tantale.

De plus, lors de la fabrication de l'empilement des niveaux d'interconnexion, diverses opérations de gravure et/ou de polissage et de nettoyage sont réalisées en phase liquide ou gazeuse. Des produits polluants peuvent donc pénétrer dans les pores du matériau diélectrique poreux pendant ces opérations. Ceci peut provoquer une dégradation du matériau poreux ou une augmentation de sa permittivité relative, ce qui annule au moins en partie l'intérêt de l'utilisation de ce matériau poreux.

Un moyen permettant de restaurer les caractéristiques du matériau diélectrique poreux consiste à effectuer, après avoir formé chaque niveau d'interconnexion, un recuit permettant d'éliminer les produits polluants présents dans le matériau diélectrique poreux.

La figure 2 est une vue en coupe illustrant un empilement de deux niveaux d'interconnexion Ni et Nᵢ₊₁. Cette figure illustre le résultat obtenu après avoir réalisé une étape de polissage mécano-chimique (CMP) sur la structure et une étape de recuit dont le but est d'éliminer les produits polluants présents dans le matériau diélectrique poreux du niveau d'interconnexion Nᵢ₊₁. Les pistes conductrices des deux niveaux d'interconnexion sont vues en coupe selon leur longueur.

Le niveau d'interconnexion Ni comprend des pistes conductrices 20 entourées d'un matériau diélectrique poreux 22. Le fond et les parois des pistes conductrices 20 sont recouverts d'une couche barrière mince 24 en un matériau conducteur évitant la diffusion du matériau conducteur des pistes conductrices 20 vers le matériau diélectrique poreux 22. Au-dessus du niveau d'interconnexion Ni s'étend une couche mince 26 en un matériau évitant la diffusion du matériau conducteur des pistes conductrices 20 vers le niveau d'interconnexion Nᵢ₊₁, par exemple en SiCN. Au-dessus de la couche mince 26 est formé le niveau d'interconnexion Nᵢ₊₁ qui comprend des pistes conductrices 28 reliées par des vias 30 aux pistes conductrices 20 du niveau d'interconnexion Ni. Un matériau diélectrique poreux 32 sépare les pistes conductrices 28 les unes des autres et les vias 30 les uns des autres. Les parois et le fond des pistes conductrices 28 et des vias 30 sont recouverts d'une couche barrière mince 34 en un matériau conducteur. Les niveaux d'interconnexion Ni et Nᵢ₊₁ peuvent être obtenus par différents procédés connus.

Lors de la formation du niveau d'interconnexion Nᵢ₊₁, les étapes de gravure et/ou de polissage et de nettoyage provoquent la contamination du matériau diélectrique poreux 32. Une étape supplémentaire, consistant à réaliser un recuit de la structure pour permettre l'évaporation des polluants, est alors réalisée. A titre d'exemple, cette étape de recuit peut être effectuée à une température d'environ 300°C pendant environ 30 minutes. Ce recuit doit être effectué avant le dépôt d'une couche homologue à la couche 26 qui constituerait une barrière à l'évaporation des polluants.

En figure 2, des flèches 36 illustrent l'évacuation, lors du recuit, des produits polluants présents dans le matériau diélectrique poreux 32. Bien que le recuit permette d'éliminer les produits polluants présents dans le matériau diélectrique poreux 32, on remarque qu'il provoque également la dilatation du matériau conducteur des pistes conductrices 28. Cette dilatation modifie la surface supérieure des pistes conductrices 28 et la rend rugueuse. Des problèmes, par exemple de fiabilité, peuvent alors se poser lorsqu'on veut former un autre niveau d'interconnexion sur la surface supérieure du niveau d'interconnexion Nᵢ₊₁. De plus, puisque le matériau diélectrique poreux 32 n'est pas protégé sur sa surface supérieure, il se pollue de nouveau au contact de l'air, notamment par de la vapeur d'eau, lorsque l'on sort la structure du four dans lequel est réalisé le recuit. Cette recontamination est illustrée en figure 2 par des flèches 38.

Pour limiter la dilatation du matériau conducteur, la température de recuit peut être diminuée. Cependant, la diminution de la température de recuit entraîne l'augmentation de la durée de ce recuit et réduit son efficacité.

### Résumé de l'invention

La présente invention a pour but de proposer un procédé de formation de niveaux d'interconnexion d'un circuit intégré permettant d'éviter au moins certains des problèmes des procédés de l'art antérieur.

Ainsi, un mode de réalisation de la présente invention prévoit un procédé de formation de niveaux d'interconnexion d'un circuit intégré comprenant les étapes suivantes:
(a) former un niveau d'interconnexion comprenant des pistes conductrices et des vias séparés par un matériau diélectrique poreux ;
(b) former, sur le niveau d'interconnexion, une couche en un matériau isolant non poreux, ladite couche comprenant des ouvertures au-dessus de portions de matériau diélectrique poreux ;
(c) répéter les étapes (a) et (b) pour obtenir le nombre adéquat de niveaux d'interconnexion ; et
(d) réaliser un recuit de la structure.

Selon un mode de réalisation de la présente invention, une étape de recuit est réalisée avant chaque répétition à l'étape (c).

Selon un mode de réalisation de la présente invention, l'étape (a) de formation d'un niveau d'interconnexion comprend les étapes suivantes:
former une couche en un matériau diélectrique poreux;
former une couche d'oxyde puis une couche en nitrure de titane sur la couche de matériau diélectrique poreux ;
former des ouvertures dans la couche en nitrure de titane et dans une partie supérieure de la couche d'oxyde au niveau des pistes conductrices désirées ;
former des trous dans la couche d'oxyde et dans une partie supérieure de la couche en matériau diélectrique poreux au niveau des vias désirés ;
graver, en dehors des zones recouvertes par la couche en nitrure de titane, jusqu'à ce que le fond des trous atteigne les pistes conductrices du niveau d'interconnexion inférieur ;
former un matériau conducteur dans la partie gravée; et
enlever les matériaux situés au-dessus de la couche de matériau diélectrique poreux.

Selon un mode de réalisation de la présente invention, l'étape de formation des trous et l'étape de gravure en dehors des zones recouvertes par la couche en nitrure de titane sont des étapes de gravure en présence d'argon et de C₄F₈.

Selon un mode de réalisation de la présente invention, l'enlèvement des matériaux situés au-dessus de la couche de matériau diélectrique poreux est réalisé par un polissage mécano-chimique (CMP).

Selon un mode de réalisation de la présente invention, les couches en matériau isolant non poreux sont en nitrure de carbone et de silicium (SiCN) et les pistes conductrices et les vias sont en cuivre.

Un mode de réalisation de la présente invention prévoit un circuit intégré comprenant un empilement de niveaux d'interconnexion, chaque niveau d'interconnexion comportant des pistes conductrices, des pistes conductrices de différents niveaux d'interconnexion étant susceptibles d'être reliées par des vias, les pistes conductrices et les vias étant séparés par des matériaux diélectriques poreux, des couches isolantes non poreuses traversées par les vias étant formées sur les différents niveaux d'interconnexion, lesdites couches isolantes non poreuses comprenant des ouvertures situées sur des portions de matériaux diélectriques poreux.

Selon un mode de réalisation de la présente invention, les matériaux diélectriques poreux ont des épaisseurs comprises entre 100 et 250 nm.

Selon un mode de réalisation de la présente invention, les couches en matériau isolant non poreux sont en nitrure de carbone et de silicium (SiCN) et les pistes conductrices et les vias sont en cuivre.

Selon un mode de réalisation de la présente invention, les ouvertures dans les couches isolantes non poreuses ont des dimensions supérieures à 70 nm.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles:
la figure 1, précédemment décrite, est une vue en coupe de plusieurs niveaux d'interconnexion d'un circuit intégré ;
la figure 2, précédemment décrite, illustre le résultat obtenu après avoir réalisé un recuit sur un niveau d'interconnexion Nᵢ₊₁; et
les figures 3A à 3I sont des vues en coupe illustrant des étapes d'un procédé de fabrication d'un empilement de niveaux d'interconnexion selon un mode de réalisation de la présente invention.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

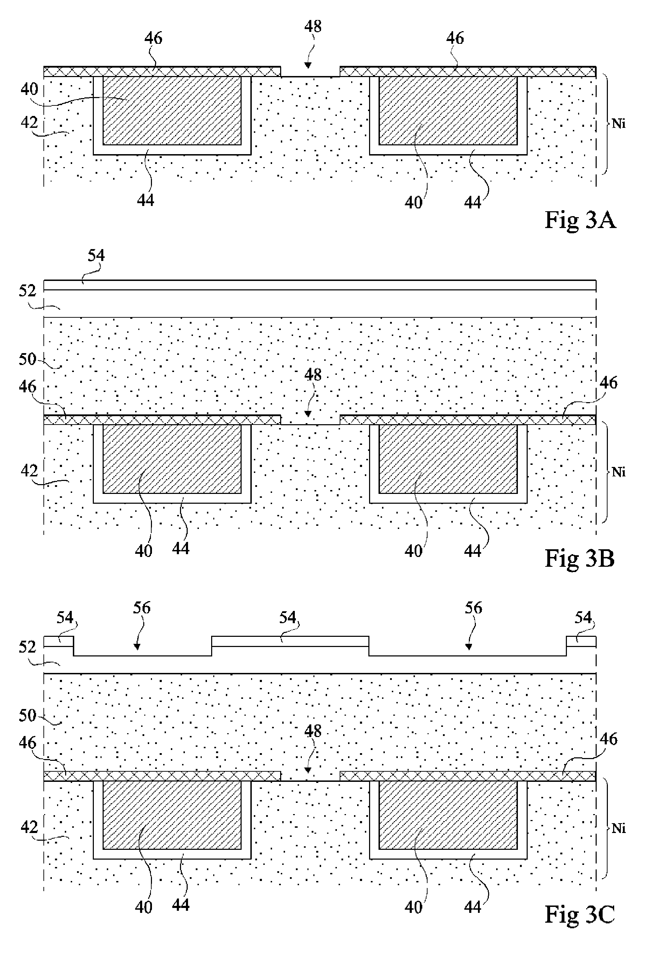

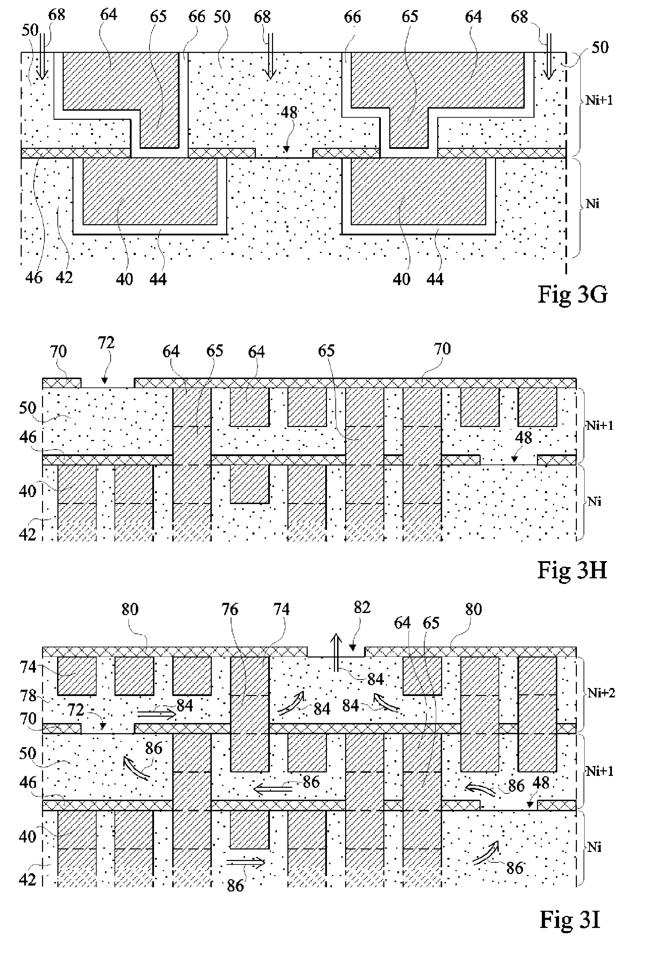

Les figures 3A à 3I sont des vues en coupe illustrant des résultats d'étapes d'un procédé de fabrication d'un empilement de niveaux d'interconnexion selon un mode de réalisation de la présente invention. Les figures 3A à 3G sont réalisées selon un premier plan de coupe et les figures 3H et 3I selon un second plan de coupe.

En figure 3A, on part d'une structure dans laquelle un niveau d'interconnexion Ni est déjà formé. Le niveau d'interconnexion Ni comprend des pistes conductrices 40, deux de ces pistes étant représentées en coupe selon leur longueur en figure 3A. A titre d'exemple, les pistes conductrices 40 peuvent être en cuivre. Des vias (non représentés) peuvent également être formés pour relier les pistes conductrices 40 à des pistes du niveau inférieur. Les pistes conductrices 40 sont séparées par un matériau diélectrique poreux 42. Les parois et le fond des pistes conductrices 40 sont recouverts d'une couche barrière mince 44 en un matériau conducteur qui empêche la diffusion du cuivre des pistes conductrices 40 vers le matériau diélectrique poreux 42. Au-dessus du niveau d'interconnexion Ni est formée une couche isolante mince non poreuse 46, par exemple en SiCN, qui empêche la diffusion du cuivre des pistes 40 vers le niveau d'interconnexion Nᵢ₊₁ qui sera formé au-dessus de cette couche isolante 46.

Selon un aspect de la présente invention, la couche isolante non poreuse 46 comporte des ouvertures 48 situées au-dessus de portions de matériau diélectrique poreux 42, une seule de ces ouvertures 48 étant représentée en figure 3A. Les ouvertures 48 sont formées au-dessus de portions du niveau d'interconnexion Ni ayant une faible densité de pistes conductrices 40.

A l'étape illustrée en figure 3B, on a formé, sur la couche isolante mince non poreuse 46, une couche plus épaisse d'un matériau diélectrique poreux 50. A titre d'exemple, la couche de matériau diélectrique poreux 50 peut être obtenue en introduisant un agent porogène dans une couche épaisse de matériau diélectrique non poreux puis en faisant réagir l'agent porogène, par exemple par un recuit, pour éliminer l'agent porogène et former les pores du matériau diélectrique poreux. Sur le dessus de la couche de matériau diélectrique poreux 50 est formé un empilement de deux couches 52 et 54 qui jouent le rôle de masque lors des étapes suivantes. A titre d'exemple, la couche 52 est une couche d'oxyde de silicium déposée, et la couche 54 est une couche de nitrure de titane (TiN).

A l'étape illustrée en figure 3C, on a formé des ouvertures 56 dans la couche de nitrure de titane 54, ces ouvertures s'étendant légèrement dans la couche d'oxyde 52. Le contour des ouvertures 56 définit le contour des pistes conductrices qui seront formées dans le niveau d'interconnexion Nᵢ₊₁. A titre d'exemple, les ouvertures 56 peuvent être formées en déposant une résine photosensible sur la couche de nitrure de titane 54, en insolant et en gravant cette résine de façon appropriée, puis en réalisant une gravure des couches 52 et 54. La couche 52 n'est gravée que partiellement pour éviter tout contact direct entre la résine et le matériau diélectrique poreux 50 lors de l'étape suivante.

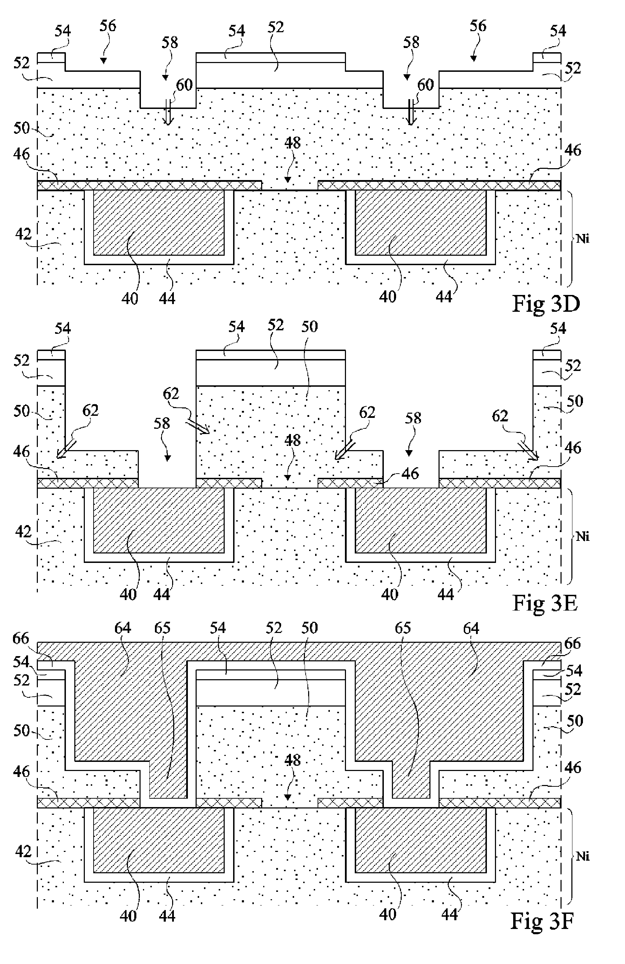

A l'étape illustrée en figure 3D, on a formé, dans les ouvertures 56, des trous 58 qui traversent la couche d'oxyde 52 et une partie supérieure de la couche de matériau diélectrique poreux 50. Les trous 58 définissent le contour des vias qui seront formés dans le niveau d'interconnexion Nᵢ₊₁. Les trous 58 peuvent être obtenus, à l'aide d'un masque adapté, par une gravure physico-chimique réalisée en présence d'argon et de C₄F₈. De plus, une étape de nettoyage à l'acide fluorhydrique (HF) est réalisée après la gravure. Lors de cette gravure et de ce nettoyage, des produits polluants (par exemple du fluor) pénètrent dans les pores du matériau diélectrique poreux 50, comme cela est représenté en figure 3D par des flèches 60.

A l'étape illustrée en figure 3E, on a réalisé une gravure de la couche d'oxyde 52 et de la couche de matériau diélectrique poreux 50 qui ne sont pas protégées par la couche de nitrure de titane 54. A titre d'exemple, cette gravure peut à nouveau être une gravure physico-chimique en présence d'argon et de C₄F₈ suivie d'un nettoyage à l'acide fluorhydrique. Cette étape de gravure permet de former le contour des pistes conductrices et des vias du niveau d'interconnexion Nᵢ₊₁. Elle est réalisée de façon que les trous 58 traversent la couche mince de SiCN 46 et qu'ils atteignent les pistes conductrices 40 du niveau d'interconnexion Ni. De la même façon qu'à l'étape précédente de gravure, des produits polluants pénètrent dans le matériau diélectrique poreux 50, lors de la gravure et du nettoyage, comme cela est indiqué par des flèches 62 en figure 3E.

A l'étape illustrée en figure 3F, on a rempli l'espace créé lors de l'étape précédente de gravure d'un matériau conducteur pour former les pistes conductrices 64 et les vias 65 du niveau d'interconnexion Nᵢ₊₁. Le matériau conducteur des pistes conductrices 64 et des vias 65 peut être du cuivre, et la métallisation est effectuée de façon que le cuivre remplisse l'espace contactant les pistes conductrices 40 du niveau d'interconnexion Ni. Une couche barrière mince 66 en un matériau conducteur évitant la diffusion du cuivre des pistes conductrices 64 et des vias 65 vers le matériau diélectrique poreux voisin 50 peut être formée avant la métallisation.

A l'étape illustrée en figure 3G, on a réalisé un polissage mécano-chimique (CMP) permettant d'enlever le surplus de cuivre et de nitrure de tantale 66 situé au-dessus de la couche de matériau diélectrique poreux 50, ainsi que la couche de nitrure de titane 54 et la couche d'oxyde 52. De la même façon que lors des étapes de gravure, pendant l'étape de polissage et l'étape de nettoyage qui la suit, des produits polluants peuvent pénétrer dans le matériau diélectrique poreux 50, comme cela est indiqué en figure 3G par des flèches 68.

Les figures 3H et 3I illustrent des étapes suivantes du procédé de fabrication selon un mode de réalisation de la présente invention, dans un plan de coupe différent de celui des figures 3A à 3G. Dans ces figures, toutes les pistes conductrices apparaissent en coupe selon leur largeur et les différentes couches barrière (44 et 66 notamment) n'ont pas été représentées par souci de simplicité.

La figure 3H illustre une structure sensiblement identique à celle de la figure 3G. Dans cette figure, les niveaux d'interconnexion Ni et Nᵢ₊₁ comprennent plusieurs pistes conductrices 40, 64 et plusieurs vias 65. Au-dessus du niveau d'interconnexion Nᵢ₊₁ est formée une couche isolante non poreuse 70, par exemple en SiCN.

Selon un aspect de la présente invention, la couche isolante non poreuse 70 comporte des ouvertures 72 au-dessus de portions de matériau diélectrique poreux 50. Dans la figure 3H, une seule de ces ouvertures 72 est représentée. Les ouvertures 72 sont formées au-dessus de portions du niveau d'interconnexion Nᵢ₊₁ ayant une faible densité de pistes conductrices 64.

A l'étape de la figure 3I, on a formé un niveau d'interconnexion Nᵢ₊₂ sur la couche mince de SiCN 70. Le niveau d'interconnexion Nᵢ₊₂ peut être formé de la même façon que le niveau d'interconnexion Nᵢ₊₁. Le niveau d'interconnexion Nᵢ₊₂ comprend des pistes conductrices 74 et des vias 76, les pistes et les vias étant séparés par un matériau diélectrique poreux 78.

Sur le dessus du niveau d'interconnexion Nᵢ₊₂ est formée une couche isolante mince non poreuse 80, par exemple en SiCN, qui comporte des ouvertures 82 au-dessus de portions de matériau diélectrique poreux 78. Dans la figure 3I, une seule de ces ouvertures 82 est représentée. De la même façon que pour les ouvertures 48 et 72, les ouvertures 82 sont formées au-dessus de portions du niveau d'interconnexion Nᵢ₊₂ à faible densité de pistes conductrices.

De préférence, après la formation de chaque ouverture 48, 72 et 82 dans les couches SiCN 46, 70 et 80 sur les niveaux d'interconnexion Ni, Nᵢ₊₁ et Nᵢ₊₂, on réalise un recuit de la structure permettant de faire évaporer les produits polluants présents dans les matériaux diélectriques poreux, respectivement 42, 50 et 78, de ces niveaux.

En figure 3I, on a représenté la circulation des produits polluants pendant un recuit destiné à éliminer les produits polluants du niveau d'interconnexion Nᵢ₊₂. Les produits polluants présents dans la couche de matériau diélectrique poreux 78 tendent à s'évaporer et à sortir par l'ouverture 82, comme cela est représenté par des flèches 84. On notera que les produits polluants contournent les vias 76 du niveau d'interconnexion Nᵢ₊₂. De plus, ce recuit permet également que des produits polluants présents dans les niveaux inférieurs remontent dans la structure, de niveau en niveau, par l'intermédiaire des ouvertures 48, 72 formées dans les couches isolantes non poreuses 46, 70, comme cela est représenté par des flèches 86, et qu'ils s'échappent de la structure par les ouvertures 82 de la couche isolante non poreuse 80.

Les couches isolantes non poreuses 46, 70 et 80 recouvrant les pistes conductrices 40, 64 et 74 empêchent la dilatation du matériau conducteur de ces pistes. Ceci permet de réaliser un recuit à des températures supérieures à celles utilisées couramment et permet donc une meilleure évacuation des produits polluants. En outre, la recontamination du matériau diélectrique poreux après les étapes de recuit ne survient que dans des régions à faible densité de matériaux conducteurs, ce qui n'augmente pas les capacités parasites dans des régions éloignées à forte densité de pistes conductrices.

Les couches isolantes non poreuses 46, 70 et 80 peuvent être en tout matériau isolant non poreux, mais elles seront de préférence en nitrure de carbone et de silicium SiCN, ce matériau stoppant le passage des produits polluants et évitant également la diffusion du matériau des pistes conductrices 40, 64 et 74 vers le matériau diélectrique poreux des niveaux supérieurs.

A titre d'exemple, les couches de matériau diélectrique poreux 42, 50, 78 ont des épaisseurs comprises entre 100 et 250 nm. Egalement à titre d'exemple, les ouvertures peuvent avoir des dimensions, côtés ou diamètres, supérieurs à 70 nm.

Des modes de réalisation particuliers de la présente invention ont été décrits. Diverses variantes et modifications apparaîtront à l'homme de l'art. En particulier, on comprendra que les étapes de recuit pourront être réalisées après avoir formé plusieurs niveaux d'interconnexion. On pourra, par exemple, former deux niveaux d'interconnexion ou plus avant de réaliser un recuit permettant d'évacuer les produits polluants de ces deux niveaux. Egalement, on pourra prévoir une étape de recuit plus longue une fois tous les niveaux d'interconnexion formés pour permettre l'évaporation des produits polluants restants dans les différents niveaux d'interconnexion.

Les ouvertures 48, 72 et 82 pourront être formées les unes au-dessus des autres ou de façon décalée, comme cela est représenté en figure 3I.

De plus, on a décrit un procédé particulier de formation d'un niveau d'interconnexion comprenant des pistes et des vias, dans lequel le matériau conducteur des pistes et des vias est formé en une seule étape. On comprendra que les pistes et les vias de chaque niveau d'interconnexion pourront être formés séparément et par tout procédé connu.

A titre d'exemple, le matériau diélectrique poreux 42, 50, 78 pourra être du "BDIIx", matériau commercialisé par Applied Materials.

## Revendications

1. Procédé de formation d'un empilement de niveaux d'interconnexion d'un circuit intégré comprenant les étapes suivantes:
(a) former un niveau d'interconnexion (Nᵢ, Nᵢ₊₁...) comprenant des pistes conductrices (40, 64, 74) formées au-dessus de vias conducteurs (65, 76), les pistes et les vias étant séparés latéralement par un matériau diélectrique poreux (42, 50, 78) ;
(b) former, sur le niveau d'interconnexion, une couche (46, 70, 80) en un matériau isolant non poreux, ladite couche comprenant des ouvertures (48, 72, 82) formées exclusivement au-dessus de portions de matériau diélectrique poreux (42, 50, 78) ;
(c) répéter les étapes (a) et (b) pour obtenir le nombre adéquat de niveaux d'interconnexion de l'empilement, les vias conducteurs d'un niveau d'interconnexion supérieur contactant des pistes conductrices d'un niveau d'interconnexion inférieur ; et
(d) réaliser un recuit de la structure.

2. Procédé selon la revendication 1, dans lequel une étape de recuit est réalisée avant chaque répétition à l'étape (c).

3. Procédé selon la revendication 1 ou 2, dans lequel l'étape (a) de formation d'un niveau d'interconnexion comprend les étapes suivantes:
former une couche en un matériau diélectrique poreux (50) ;
former une couche d'oxyde de silicium (52) puis une couche en nitrure de titane (54) sur la couche de matériau diélectrique poreux (50) ;
former des ouvertures (56) dans la couche en nitrure de titane (54) et dans une partie supérieure de la couche d'oxyde (52) au niveau des pistes conductrices désirées ;
former, dans le fond des ouvertures (56), des trous (58) dans la couche d'oxyde (52) et dans une partie supérieure de la couche en matériau diélectrique poreux (50, 78) au niveau des vias conducteurs désirés ;
graver, en dehors des zones recouvertes par la couche en nitrure de titane (54), jusqu'à ce que le fond des trous (58) atteigne les pistes conductrices d'un niveau d'interconnexion inférieur ;
former un matériau conducteur (64, 65, 74, 76) dans la partie gravée ; et
enlever les matériaux situés au-dessus de la couche de matériau diélectrique poreux (50, 78).

4. Procédé selon la revendication 3, dans lequel l'étape de formation des trous (58) et l'étape de gravure en dehors des zones recouvertes par la couche en nitrure de titane (54) sont des étapes de gravure en présence d'argon et de C₄F₈.

5. Procédé selon la revendication 3 ou 4, dans lequel l'enlèvement des matériaux situés au-dessus de la couche de matériau diélectrique poreux (50, 78) est réalisé par un polissage mécano-chimique (CMP).

6. Procédé selon l'une quelconque des revendications précédentes, dans lequel les couches en matériau isolant non poreux (46, 70, 80) sont en nitrure de carbone et de silicium (SiCN) et les pistes conductrices (40, 64, 74) et les vias conducteurs (65, 76) sont en cuivre.

7. Circuit intégré comprenant un empilement de niveaux d'interconnexion, chaque niveau d'interconnexion (Nᵢ, Nᵢ₊₁...) de l'empilement comportant des pistes conductrices (40, 64, 74), et des vias conducteurs, des pistes conductrices de différents niveaux d'interconnexion étant adaptées à être reliées par les vias (65, 76), les pistes et les vias d'un même niveau d'interconnexion étant séparés latéralement par des matériaux diélectriques poreux (42, 50, 78), des couches isolantes non poreuses (46, 70, 80) traversées par les vias étant formées sur chaque niveau d'interconnexion, lesdites couches isolantes non poreuses comprenant des ouvertures (48, 72, 82) situées exclusivement sur des portions de matériaux diélectriques poreux.

8. Circuit intégré selon la revendication 7, dans lequel les matériaux diélectriques poreux (42, 50, 78) ont des épaisseurs comprises entre 100 et 250 nm.

9. Circuit intégré selon la revendication 7 ou 8, dans lequel les couches en matériau isolant non poreux (46, 70, 80) sont en nitrure de carbone et de silicium (SiCN) et les pistes conductrices (40, 64, 74) et les vias conducteurs (65, 76) sont en cuivre.

10. Circuit intégré selon l'une quelconque des revendications 7 à 9, dans lequel les ouvertures (48, 72, 82) dans les couches isolantes non poreuses (46, 70, 80) ont des dimensions supérieures à 70 nm.
